# DEMANDE DE BREVET EUROPEEN

(11) **EP 1 215 949 A1**
(43) Date de publication de la demande: **19.06.2002**
(21) Numéro de dépôt: 01204676.9
(22) Date de dépôt: 04.12.2001
(51) Int. Cl.: H05K 5/00

(54) **Boitier d'appareil électronique**

(30) Priorité: 12.12.2000 FR 0016165
(71) Demandeur: Koninklijke Philips Electronics N.V., 5621 BA Eindhoven (NL)
(72) Inventeur: Flegeo, Arnaud, Société Civile S.P.I.D., 75008 Paris (FR)
(74) Mandataire: Chaffraix, Jean

(57) **Abrégé**

L'invention concerne un boîtier (10) d'appareil électronique du type qui comporte une partie principale ou corps (24) avec une ouverture et une partie mobile ou couvercle (28), formant couvercle d'obturation de l'ouverture, entre une position assemblée sur le corps (24) et une position démontée, du type dans lequel le couvercle (28) comporte au moins un crochet (40) qui est retenu, en position assemblée, par un cran (42) escamotable qui est monté mobile, dans des moyens de guidage (44) du boîtier (10), entre une position verrouillée et une position déverrouillée, caractérisé en ce que le cran (42) escamotable appartient à un élément de verrouillage (46) qui est guidé en translation selon une direction longitudinale globalement orthogonale à la direction selon laquelle s'étend le crochet (40) et qui comporte une portion de tige longitudinale qui coopère avec le crochet (40), et en ce que le boîtier (10) comporte des moyens de retenue de la portion de tige en position verrouillée.

## Description

L'invention propose un boîtier d'appareil électronique qui comporte un corps avec une ouverture et une partie mobile, formant couvercle d'obturation de l'ouverture.

L'invention propose plus particulièrement un boîtier d'appareil électronique du type qui comporte une partie principale ou corps avec une ouverture et d'une partie, formant couvercle d'obturation de l'ouverture, mobile entre une position assemblée sur le boîtier et une position démontée.

L'invention concerne aussi un appareil électronique formé d'un tel boîtier.

Il existe de nombreux boîtiers de ce type tels que des boîtiers de téléphones mobiles du type GSM, ou de rasoirs.

En effet, le corps de tels boîtiers peut comporter une ouverture permettant l'accès à un compartiment tel qu'un compartiment de piles.

Le couvercle peut aussi consister en une paroi formant face complète du boîtier.

Pour un téléphone mobile cette paroi peut être la paroi avant ou principale du téléphone qui est traversée par des touches d'un clavier et par un écran de visualisation.

Dans les deux cas, l'utilisateur de l'appareil électronique peut être amené à ouvrir le boîtier, c'est-à-dire à séparer le couvercle du corps.

Dans le premier cas, l'ouverture peut permettre le changement des piles. Il peut aussi permettre d'ajouter ou d'enlever un accessoire de façon à adapter l'appareil électronique.

Dans le second cas, l'ouverture peut permettre le changement du couvercle pour le remplacer par un autre couvercle présentant un effet esthétique différent, tel que la couleur. L'opération de remplacement du couvercle du boîtier permet la personnalisation du boîtier, elle est aussi appelée "customisation".

De façon connue, l'assemblage du couvercle et du corps est réalisé par un assemblage vissé. Un tel assemblage pose un problème d'outillage.

En effet, à chaque fois que l'utilisateur veut ouvrir le boîtier, par exemple pour changer les piles, il doit disposer d'un tournevis adapté.

La vis est engagée dans un filetage complémentaire. Les boîtiers étant généralement fabriqués en plastique, il est nécessaire pour assurer une résistance suffisante, que le filetage soit réalisé dans un insert métallique qui est rapporté dans l'une des parties du boîtier.

L'agencement des inserts réalisé à l'intérieur du boîtier diminue le volume de ce dernier.

Une telle solution est onéreuse puisque l'assemblage du boîtier nécessite deux éléments supplémentaires qui sont la vis et l'insert.

Les temps de vissage et de dévissage sont importants ce qui augmente le temps nécessaire pour l'assemblage du boîtier lors de la fabrication de l'appareil électronique, mais aussi le temps d'ouverture et de fermeture du boîtier. De plus, il existe un risque de perdre les vis.

Une autre solution consiste en l'engagement ou emboîtement élastique du bec d'un crochet d'une partie du boîtier dans une forme complémentaire en creux de l'autre partie du boîtier. Bien que l'assemblage du corps et du couvercle soit simple et facile à réaliser, cette solution ne permet pas le démontage aisé du corps et du couvercle, sans risque de détérioration de l'une ou l'autre des parties du boîtier.

Pour permettre le dégagement du crochet de la forme en creux, il est connu que, pour chaque couple d'élément, l'un d'entre eux soit mobile.

Par exemple, lorsque le crochet est réalisé en une pièce avec un bord libre d'une paroi d'une des parties du boîtier, la déformation, dans un sens opposé au sens de la direction de l'engagement du bec du crochet dans la forme complémentaire en creux de l'autre partie, permet le dégagement du bec.

Cependant, la paroi qui supporte le crochet doit être suffisamment résistante pour satisfaire aux exigences fonctionnelles du boîtier et suffisamment flexible pour permettre sa déformation permettant le dégagement du bec. Ces deux conditions sont difficiles à satisfaire. Ainsi, il est fréquent qu'après plusieurs cycles d'assemblage/désassemblage du boîtier, il y ait rupture de la paroi qui porte le crochet. Cette rupture est due principalement à l'application d'un effort pour déformer le crochet qui est supérieur à l'effort minimal nécessaire.

De plus, la déformation de la paroi qui porte le crochet nécessite un espace libre à l'intérieur du boîtier. Cela augmente les dimensions et l'encombrement du boîtier.

Selon une variante, c'est la forme complémentaire en creux formant cran qui est mobile entre une position de verrouillage dans laquelle il retient le crochet pour maintenir le corps et le couvercle en position assemblée, et une position déverrouillée dans laquelle il libère le crochet pour permettre le démontage du couvercle.

Lorsque le cran est réalisé en une pièce avec la paroi dont il est solidaire, cette solution présente les mêmes inconvénients que ceux présentés précédemment.

Le cran peut aussi consister en un élément rapporté sur une partie du boîtier. Cette solution est difficile à réaliser car elle nécessite un montage complexe permettant l'assemblage et le guidage de l'élément rapporté sur la partie associée du boîtier.

De façon à fournir une solution à ce problème, l'invention propose un boîtier d'appareil électronique du type qui comporte une partie principale ou corps avec une ouverture et d'une partie, formant couvercle d'obturation de l'ouverture, mobile entre une position assemblée sur le corps et une position démontée, du type dans lequel le couvercle comporte au moins un crochet qui s'étend à l'intérieur du corps et qui est retenu, en position assemblée, par un cran escamotable qui est monté mobile, dans des moyens de guidage du boîtier, entre une position verrouillée dans laquelle il retient le crochet pour maintenir le corps et le couvercle en position assemblée et une position déverrouillée dans laquelle il libère le crochet pour permettre le démontage de couvercle, remarquable en ce que le cran escamotable appartient à un élément de verrouillage qui est guidé en translation selon une direction longitudinale globalement orthogonale à la direction selon laquelle s'étend le crochet et qui comporte une portion de tige longitudinale qui coopère avec le crochet, et en ce que le boîtier comporte des moyens de retenue de la portion de tige en position verrouillée.

Selon d'autres caractéristiques de l'invention :
- le couvercle comporte au moins deux crochets qui sont retenus en position assemblée par au moins deux portions associées de tige appartenant à un élément de verrouillage commun aux deux crochets ;
- les deux crochets sont sensiblement alignés longitudinalement, et l'élément de verrouillage commun est une tige dont deux tronçons forment lesdites portions de tige dont chacune coopère avec un crochet associé ;
- le boîtier comporte au moins deux crochets qui sont opposés transversalement, et l'élément de verrouillage est une épingle en forme de U dont les deux branches longitudinales parallèles portent respectivement deux portions de tige dont chacune coopère avec un crochet associé ;
- en position verrouillée, la branche transversale intermédiaire de l'épingle en forme de U, formant organe de préhension, est reçue dans un premier logement formé dans une paroi du boîtier ;
- les moyens de retenue comportent un bossage qui s'étend, à l'intérieur du premier logement, et qui, en position verrouillée s'étend en regard de la branche intermédiaire, de façon à immobiliser l'élément de verrouillage au moins dans un sens selon la direction longitudinale ;
- les moyens de retenue comportent un volet de blocage qui est monté mobile, dans une paroi du boîtier, entre une position de blocage et une position effacée de façon à empêcher ou non le mouvement de la branche intermédiaire de l'élément de verrouillage au moins dans un sens selon la direction longitudinale ;
- les moyens de retenue comportent au moins un second logement dans lequel est réalisé au moins un trou qui reçoit par engagement serré au moins une extrémité libre de l'élément de verrouillage de façon à arrêter ce dernier en translation longitudinale ;
- l'élément de verrouillage comporte une zone de retenue, telle qu'une variation de section, qui en position verrouillée, coopère avec un organe complémentaire, telle qu'une pince ;
- l'élément de verrouillage comporte une encoche qui est adjacente à ladite portion de tige et qui, en position déverrouillée, est en regard du crochet associé à ladite portion de tige et permet sa libération pour séparer le corps et le couvercle ;
- le crochet comporte un tronçon de raccordement dont une extrémité est solidaire du couvercle et dont l'autre extrémité forme un bec qui, en position assemblée, coopère avec l'élément de verrouillage ;
- le tronçon de raccordement du crochet est déformable élastiquement selon une direction transversale sensiblement perpendiculaire à la direction longitudinale de la portion de tige, de façon que le bec s'escamote lors de l'assemblage puis soit retenu par la portion de tige lorsque le cran mobile est en position verrouillée ;
- l'extrémité libre du crochet est conformée en une rampe qui coopère avec la périphérie du cran lors de l'assemblage pour provoquer l'escamotage du crochet par déformation élastique ;
- le boîtier est globalement parallélépipédique, et au moins deux crochets s'étendent à proximité des deux faces internes des parois d'orientation longitudinale opposées respectivement du boîtier ;
- le boîtier comporte des moyens d'articulation qui sont décalés par rapport à au moins un crochet et qui permettent l'articulation du boîtier et du couvercle de façon que lorsque le cran escamotable est en position déverrouillée, l'ouverture du boîtier est obtenue par pivotement du couvercle selon l'axe des moyens d'articulation.

D'autres caractéristiques et avantages de l'invention apparaîtront à la lecture de la description détaillée qui suit pour la compréhension de laquelle on se reportera aux figures annexées parmi lesquelles :
- la figure 1 est une vue en perspective d'un boîtier d'appareil électronique réalisé selon un premier mode de réalisation de l'invention ;
- la figure 2 est une vue en coupe longitudinale du boîtier d'appareil électronique selon la ligne II-II représentée à la figure précédente ;
- la figure 3 est une vue en perspective et en détail d'un crochet pour l'assemblage du boîtier ;
- la figure 4 est une vue en coupe transversale du boîtier d'appareil électronique selon la ligne IV-IV représentée à la figure 2 ;
- la figure 5 est une vue en perspective d'un boîtier d'appareil électronique réalisé selon un deuxième mode préféré de réalisation de l'invention ;
- la figure 6 est une vue en coupe longitudinale du boîtier d'appareil électronique selon la ligne VI-VI représentée à la figure précédente ;
- la figure 7 est une vue partielle en coupe longitudinale de la partie avant du boîtier selon une variante de réalisation de l'invention, comportant un volet de blocage représenté en position de blocage ;
- la figure 8 est une vue similaire à celle représentée à la figure précédente, le volet de blocage étant représenté en position effacée ;
- la figure 9 est une vue en coupe longitudinale d'un exemple de réalisation de moyens de retenue d'un élément de verrouillage du boîtier ;
- la figure 10 est une vue en coupe transversale du boîtier en coupe selon la ligne X-X de la figure 5, lors de l'assemblage de deux parties le constituant ;
- la figure 11 est une vue similaire à celle représentée à la figure précédente, le boîtier étant assemblé ;
- la figure 12 est une vue partielle en coupe à grande échelle, selon un plan horizontal, l'élément de verrouillage étant représenté en position verrouillée selon une variante de l'invention ;
- la figure 13 est une vue similaire à celle représentée à la figure précédente, l'élément de verrouillage étant représenté en position déverrouillée.

Dans la suite la description, des éléments identiques ou similaires seront désignés par les mêmes chiffres de référence.

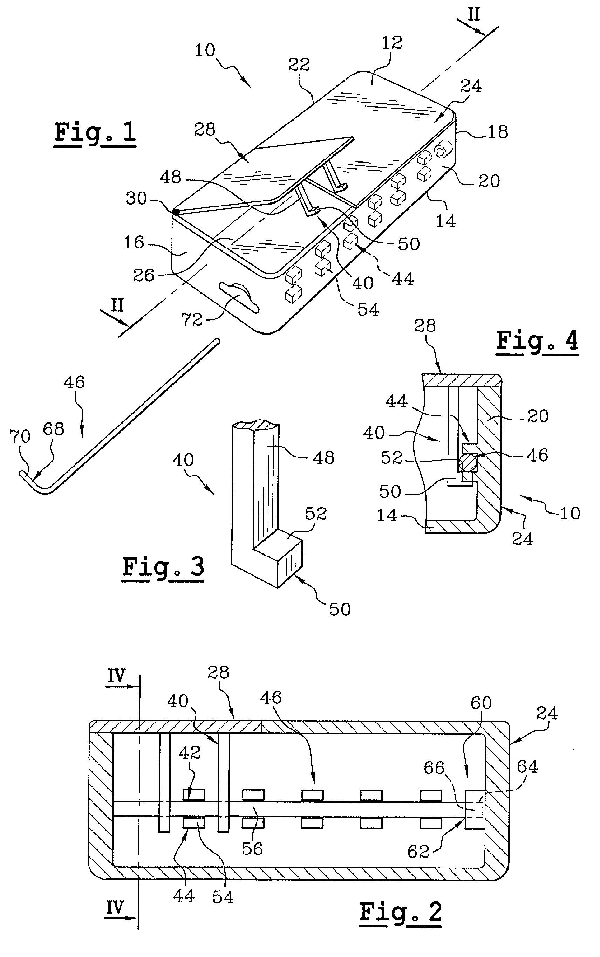

Dans la suite la description on utilisera à titre non limitatif une orientation longitudinale et une orientation transversale conformément aux lignes II-II et IV-IV représentées aux figures 1 et 2 respectivement. Une orientation supérieure inférieure sera aussi utilisée notamment conformément à la figure 1.

La figure 1 représente un boîtier 10 destiné à recevoir un appareil électronique non représenté.

Le boîtier 10 est ici un parallélépipède qui présente conformément à la figure 1 une paroi supérieure 12 et une paroi inférieure 14 qui s'étendent dans des plans horizontaux, ainsi qu'une paroi avant 16, une paroi arrière 18 et deux parois latérales 20 et 22 qui sont globalement verticales.

Le boîtier 10 comporte une partie principale ou corps 24 avec une ouverture 26 réalisée dans la paroi supérieure 12. L'ouverture 26 permet l'accès à une cavité qui reçoit par exemple les piles d'alimentation ou un élément modulaire, telle qu'une extension de mémoire, de l'appareil électronique.

Le boîtier 10 comporte aussi une partie mobile 28, formant couvercle d'obturation de l'ouverture 26. Le couvercle 28 est mobile entre une position assemblée sur le corps 24 et une position démontée ou ouverte représentée à la figure 1.

Ici, le couvercle 28 est articulé par rapport au corps 24 par une articulation 30 selon une direction longitudinale. L'articulation 30 peut être une charnière de type connu qui solidarise le bord supérieur libre de la paroi latérale 22 du corps 24 et le bord libre en vis-à-vis du couvercle 28.

Selon une variante, l'articulation 30 consiste en des moyens complémentaires du corps 24 et du couvercle 28 qui coopèrent lorsque le couvercle 28 est en position assemblée, et qui se séparent lorsque le couvercle 28 est en position ouverte de façon à permettre leur séparation complète.

De façon à maintenir ou verrouiller le boîtier 10 en position assemblée, le couvercle 28 comporte des crochets 40 qui, en position assemblée, s'étendent à l'intérieur du corps 24 et coopèrent avec des crans escamotables 42, représentés notamment à la figure 2.

Le boîtier 10 comporte ici deux crochets 40 qui sont alignés longitudinalement et qui sont agencés à proximité du bord libre latéral du couvercle 28 qui est opposé à la charnière 30.

Chaque crochet 40 comporte un tronçon 48 de raccordement dont une extrémité supérieure est solidaire du couvercle 28 et dont l'autre extrémité inférieure forme un bec 50.

Le bec 50, représenté en détail et en perspective à la figure 3, comporte une face 52 de retenue qui est sensiblement horizontale et orientée perpendiculairement à la direction globale du crochet 40.

Les crans escamotables 42 sont montés mobiles entre une position verrouillée, représentée aux figures 2 et 4, dans laquelle ils retiennent les crochets 40, et une position déverrouillée, représentée à la figure 1, dans laquelle ils libèrent les crochets 40 pour permettre le démontage du couvercle 28.

Les crans escamotables 42, sont guidés dans des moyens de guidage 44 du boîtier 10.

Selon l'invention, les crans escamotables 42 appartiennent à un élément de verrouillage 46.

L'élément 46 de verrouillage est ici guidé en translation selon une direction longitudinale globalement orthogonale à la direction selon laquelle s'étendent les crochets 40 et qui comporte des portions 56 de tige longitudinale qui coopèrent avec les crochets 40. Conformément à la figure 4, la section transversale des portions 56 de tige est circulaire. Selon une variante, la section transversale 56 peut être différente, notamment carrée.

Les moyens de guidage 44 consistent en des portions de nervures 54 qui permettent de retenir les crans escamotables 42 vers le haut et vers le bas. Les portions de nervures 54 sont agencées longitudinalement et décalées longitudinalement par rapport aux crans 42, conformément à la figure 2, de façon à permettre le passage des crans escamotables 42, notamment de leurs becs 50, lors de leurs mouvements entre la position assemblée et la position ouverte du couvercle 28.

En position verrouillée, représentée la figure 2, les crans escamotables 42 retiennent les crochets 40 par coopération avec les faces 52 de retenue des becs 50.

En position déverrouillée, représentée à la figure 1, les crans escamotables 42 libèrent les crochets 40 pour permettre le démontage du couvercle 28. Ici l'élément de verrouillage 46 est sorti du boîtier 10.

Le boîtier 10 comportant plusieurs crochets 40, les portions de tige 56 associées aux crochets 40 appartiennent à l'élément de verrouillage 46 qui est avantageusement commun aux deux crochets 40.

Le boîtier 10 comporte aussi des moyens 60 de retenue de l'élément de verrouillage 46 en position verrouillée.

Les moyens 60 de retenue comportent un logement 62 dans lequel est réalisé un trou 64 qui reçoit, par engagement à force, l'extrémité libre arrière 66 de l'élément de verrouillage 46. Ainsi, lorsque l'extrémité libre arrière 66 est engagée dans le trou 64, l'élément de verrouillage 46 est arrêté en translation longitudinale dans la position verrouillée.

L'extrémité arrière 68 de l'élément de verrouillage 46 est courbée selon une direction transversale de façon à former un organe de préhension 70.

La paroi avant 16 du corps 24 comporte un orifice 72 qui permet le passage de la partie avant de l'élément de verrouillage 46 et qui constitue aussi un logement pour l'organe de préhension 70 lorsque l'élément de verrouillage 46 est en position verrouillée.

Pour fermer le boîtier 10, le couvercle 28 est mis en position assemblée puis l'élément de verrouillage 46 est engagé longitudinalement dans l'orifice 72. Il est guidé par les moyens de guidage 44 constitués par les portions de nervures 54 qui permettent le guidage de l'élément de verrouillage 46 vers le haut et vers le bas, ainsi que par les tronçons 48 de raccordement des crochets 40 et la paroi transversale 20 du corps 14 qui guident transversalement l'élément de verrouillage 46.

L'engagement longitudinal se poursuit jusqu'à ce que l'extrémité libre arrière 66 de l'élément de verrouillage 46 soit engagée dans le trou 64, c'est-à-dire jusqu'à ce que l'élément de verrouillage 46 soit en position verrouillée.

L'élément de verrouillage 46 retient alors les faces 52 des crochets 40.

L'élément de verrouillage 46 est solidaire du boîtier 10 et empêche l'ouverture du couvercle 28.

Pour ouvrir le boîtier 10, l'utilisateur tire, longitudinalement vers l'extérieur du boîtier, sur l'organe de préhension 70. L'extrémité libre arrière 66 de l'élément de verrouillage 46 est dégagée du trou 64. Lorsque l'organe de préhension 70 est sorti du boîtier 10, les crochets 40 sont libérés et le couvercle 28 peut être ouvert librement vers sa position démontée.

Un boîtier 10 selon l'invention est très avantageux. En effet, le démontage du couvercle 28 est obtenu sans outillage spécifique puisque l'utilisateur peut facilement manoeuvrer l'organe de préhension 70 avec l'extrémité de l'un de ses doigts.

De plus le démontage du couvercle 28 ne nécessite aucune déformation d'une partie du boîtier, ce qui supprime toute fatigue du matériau le constituant. Ainsi, le cycle d'assemblage/désassemblage du boîtier 10 peut être réalisé un grand nombre de fois sans risquer de détériorer un élément le constituant.

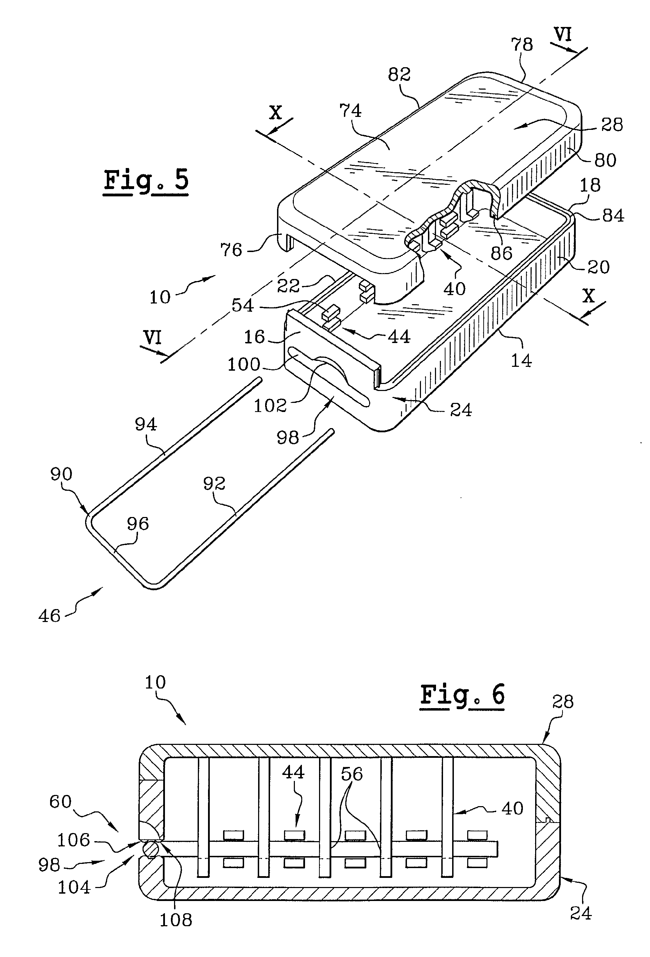

Selon un second mode de réalisation préféré représenté à la figure 5, l'invention propose que le corps 24 et le couvercle 28 consistent en une première coque inférieure et une seconde coque supérieure respectivement.

La seconde coque 28 comporte une paroi supérieure 74 en vis-à-vis de la paroi inférieure 14 de la première coque 24. La seconde coque 28 comporte aussi, de façon similaire à la première coque 24, une paroi avant 76, une paroi arrière 78 ainsi que deux parois latérales 80 et 82.

Un tel type de boîtier 10 est notamment utilisé pour des téléphones mobiles. Le corps 24 reçoit l'appareil électronique et le couvercle 28 constitue alors la face principale ou façade du téléphone.

L'utilisateur du téléphone peut être amené à démonter le boîtier 10, notamment pour changer le couvercle 28 en vue de personnaliser son appareil. Dans la pratique, l'utilisateur possède plusieurs couvercles 28 différents qu'il assemble sur le corps 24 selon ses envies ou ses besoins.

L'invention permet d'assembler et de démonter facilement, rapidement et fréquemment la seconde coque 28, sans risque de détérioration du boîtier 10.

Pour éviter le glissement des coques 26 et 28 l'une sur l'autre dans un plan horizontal lorsque le boîtier 10 est assemblé, une nervure 84 et un creux complémentaire 86 sont réalisés sur les bords libres des parois latérales 20, 22, 80, 82, avant 16, 76 et arrière 18, 78 de la première et de la seconde coques 24 et 28 respectivement.

Le boîtier 10 comporte deux rangées longitudinales de crochets 40 qui sont opposées transversalement et qui sont ici situées à proximité des parois latérales 80 et 82 de la seconde coque 28.

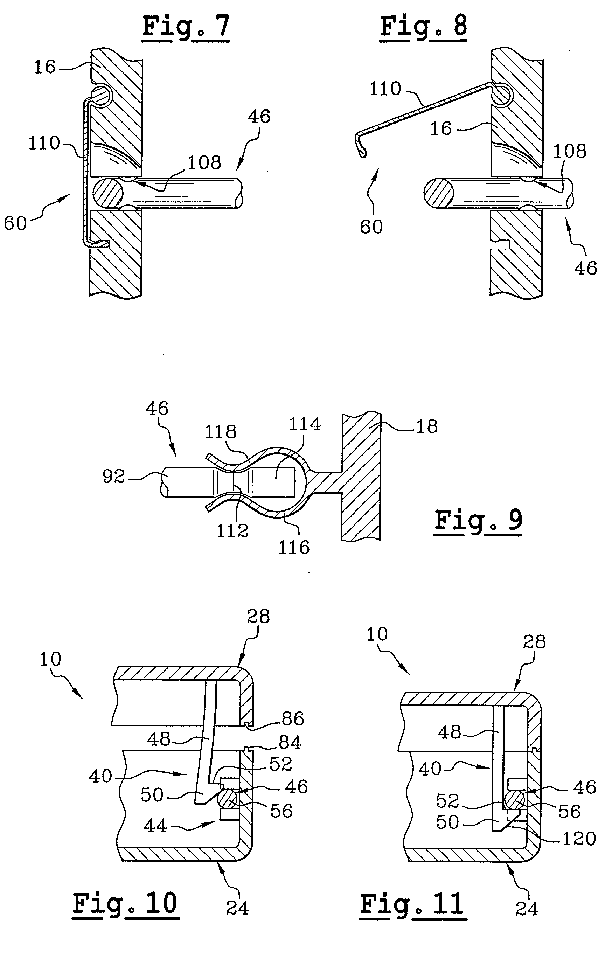

Pour faciliter l'assemblage et le démontage du boîtier 10, l'élément de verrouillage 46 est une épingle 90 en forme de U dont les deux branches longitudinales parallèles arrières 92 et 94 comportent les portions de tige 56 (figures 2 et 6) qui, en position assemblée de la seconde coque 28, coopèrent avec les faces de retenue 52 des crochets 40 associés.

L'épingle 90 comporte aussi une branche transversale intermédiaire 96 formant organe de préhension.

L'épingle 90 est avantageusement réalisée par pliage d'un fil métallique de section circulaire.

En position verrouillée, la branche transversale intermédiaire 96 est reçue dans un logement 98 formé dans la paroi avant 16 de la première coque 24.

Le logement 98 comporte une ouverture oblongue 100 d'orientation transversale qui permet de recevoir la branche transversale intermédiaire 96. La hauteur de l'ouverture oblongue 100 est sensiblement égale au diamètre de la branche 96.

Une encoche 102 réalisée dans la face avant de la paroi avant 16 débouche verticalement dans l'ouverture 100. L'encoche 102 permet à l'utilisateur de dégager la branche transversale 96 du logement 98 lorsqu'elle est en position verrouillée, conformément à la figure 6.

Ici, les moyens 60 de retenue de l'élément de verrouillage 46 en position verrouillée sont réalisés dans le logement 98.

Les moyens 60 de retenue comportent des bossages 104 qui s'étendent à l'intérieur du logement 98.

Les bossages 104 sont ici au nombre de quatre. Chaque face supérieure et inférieure du logement 98 comporte deux bossages qui sont chacun agencé en vis-à-vis d'un bossage associé de l'autre face, et agencé en avant et en arrière de la branche transversale intermédiaire 96 lorsque l'élément de verrouillage 46 est en position verrouillée. Ainsi, les moyens 60 de retenue comportent un couple avant 106 et un couple arrière 108 de bossages 104.

Les couples avant 106 et arrière 108 permettent de réduire la hauteur de passage à l'intérieur du logement 98 de façon à immobiliser l'élément de verrouillage 46, chacun selon une direction longitudinale.

Le passage de la branche transversale 96 entre les bossages 104 du couple avant 106 provoque leur déformation élastique.

Les bossages 104 du couple arrière 108 peuvent être similaires aux bossages du couple avant 106.

Avantageusement, leur hauteur est supérieure à la hauteur des bossages du couple avant 106 de façon à former butées pour bloquer la translation longitudinale vers l'arrière de l'élément de verrouillage pour empêcher que la branche transversale 96 ne pénètre à l'intérieur du boîtier 10.

Lorsque l'élément de verrouillage 46 est en position verrouillée, c'est-à-dire que la branche 96 est située entre les couples de bossages avant 106 et arrière 108, il est nécessaire d'exercer un effort suffisant, de direction axiale, orienté vers l'avant, pour déformer élastiquement à nouveau les deux bossages du couple avant 106 et libérer l'élément de verrouillage 46.

Selon une variante, le couple arrière 108 formant butées est une paroi transversale, non représentée, qui ferme partiellement vers l'arrière le logement 98. Dans ce cas, la paroi transversale s'étend en vis-à-vis de la branche transversale 96 de façon à laisser libre le passage des branches longitudinales 92 et 94 vers l'intérieur du boîtier 10.

Selon une autre variante, le couple avant 106 est remplacé par un volet de blocage 110 mobile, représenté aux figures 7 et 8.

Le volet de blocage 110 est alors monté articulé par rapport à la paroi avant 16 entre une position de blocage, représentée à la figure 7, dans laquelle il immobilise l'élément de verrouillage 46 selon la direction longitudinale vers l'avant, et une position effacée, représentée à la figure 8.

Le volet 110 peut être moulé en une seule pièce avec un composant du boîtier 10 avec sa charnière d'articulation sous la forme d'un film moulé.

Conformément à la figure 9, les moyens 60 de retenue peuvent aussi consister en une zone de retenue 112 qui est réalisée sur une branche longitudinale par exemple la branche longitudinale 92, à proximité de l'extrémité libre 114 longitudinale arrière, et qui coopèrent en position verrouillée avec un organe complémentaire 116 du boîtier 10.

Ici, la zone de retenue 112 consiste en une variation de section de la branche longitudinale 92 qui coopère avec une pince complémentaire 116 fixée sur la paroi arrière 18 de la première coque 24. La pince 116 est constituée de deux lames 118 déformables élastiquement dont les extrémités libres avant sont conformées de façon complémentaire à la zone de retenue 112 de la branche longitudinale 92.

Ainsi, lorsque l'élément de verrouillage 46 est engagé longitudinalement dans le boîtier 10 vers sa position verrouillée, son extrémité libre 114 provoque l'écartement des deux lames 118 qui se resserrent lorsque leurs extrémités conformées coopèrent avec la zone de retenue 112. Les lames 118 immobilisent alors l'élément de verrouillage dans les deux sens de la direction longitudinale.

Pour dégager la zone de retenue 112 de la pince complémentaire 116, il est nécessaire d'exercer un effort suffisant, de direction axiale et orienté vers l'avant, pour écarter à nouveau les deux lames 118 et libérer l'élément de verrouillage 46.

Le verrouillage de l'assemblage du boîtier 10 réalisé selon le second mode de réalisation peut être similaire à celui du boîtier 10 réalisé selon le premier mode de réalisation, c'est-à-dire que la seconde coque 28 est assemblée avec la première coque 24, puis l'épingle de verrouillage 90 est introduite dans le boîtier 10 par le logement 98 et guidée dans les moyens de guidage 44 pour verrouiller l'assemblage.

De préférence, les opérations sont inversées. En effet, l'invention propose que l'épingle de verrouillage 90 soit introduite dans le boîtier 10 jusqu'à sa position de verrouillage. Ensuite, la première 24 et la seconde coque 28 sont positionnées en vis-à-vis l'une de l'autre. Elles sont rapprochées selon une direction verticale jusqu'à ce que les becs 50 des crochets 40 entrent en contact avec les portions de tige 56 associées de l'épingle de verrouillage 90.

Le tronçon de raccordement 48 de chaque crochet est alors déformé élastiquement selon une direction sensiblement perpendiculaire à la direction longitudinale de la portion de tige 56 correspondante. Ainsi le bec 50 correspondant s'escamote transversalement conformément à la figure 10.

Le tronçon de raccordement 48 se comporte alors comme une poutre soumise à de la flexion selon une direction sensiblement perpendiculaire à son axe général.

Pour faciliter la déformation du tronçon de raccordement 48 et l'escamotage du bec 50 du crochet 40, l'extrémité libre inférieure du crochet 40 est avantageusement conformée en une rampe 120.

Ainsi, lorsque la rampe 120 coopère avec la périphérie de la portion de tige 56 de l'épingle 90, le bec 50 s'escamote et permet le rapprochement des deux coques 24 et 28.

L'élasticité du tronçon de raccordement 48 permet le retour des crochets 40 dans une position sensiblement verticale lorsque la face de retenue 52 du bec 50 est au niveau de la partie inférieure de la portion de tige 56 (voir figure 11).

La longueur des crochets 40 ainsi que les dimensions des parois latérales 20, 22, 80 et 82 et la position de l'épingle 90 par rapport au bord supérieur des faces latérales 20 et 22 de la première coque 24 sont déterminées de façon que, lorsque les deux coques 24 et 28 sont assemblées, il existe un jeu de fonctionnement minimal entre la face de retenue 52 des crochets 40 est la partie inférieure des portions de tige 56.

Ainsi, le verrouillage de l'assemblage est réalisé par déformation et retour élastique des crochets 40, aussi appelé emboîtement élastique ou "clipsage".

Le démontage du boîtier 10 consiste alors à extraire l'épingle 90 du boîtier 10 de façon à libérer les faces de retenue 52 des crochets 40 et permettre l'écartement selon une direction verticale des deux coques 24 et 28. L'extraction de l'épingle 90 est obtenue par un effort de traction exercé sur la branche transversale 96 selon la direction longitudinale vers l'avant du boîtier 10.

Ainsi, l'assemblage, le verrouillage de l'assemblage et le démontage du boîtier 10 sont réalisés de façon simple et rapide. De plus, ils peuvent être réalisés un très grand nombre de fois sans risque de détériorer l'un des éléments du boîtier 10.

Même si les branches longitudinales 92 et 94 ne sont pas parfaitement rectilignes, notamment dans le plan horizontal, il est possible d'introduire l'épingle 90 dans le boîtier 10 jusqu'à sa position verrouillée car leur guidage transversal n'est réalisé par les tronçons de raccordement 48 qu'après l'assemblage et le verrouillage du boîtier 10.

Selon l'invention, il est possible d'augmenter le nombre de crochets 40 de la seconde coque 28 sans modifier l'épingle 90.

L'augmentation du nombre de crochets 40 permet de réduire leurs dimensions tout en conservant une même résistance de l'assemblage. La réduction des dimensions des crochets 40 permet ainsi de réduire leur encombrement et par conséquent offre un volume utile à l'intérieur du boîtier 10 plus important.

Selon l'invention, le positionnement longitudinal des crochets 40, ne nécessite pas une grande précision. En effet, les crans escamotables 42 avec lesquels ils coopèrent consistent ici en un élément de verrouillage 46 longitudinal qui s'étend sur quasiment toute la longueur du boîtier 10.

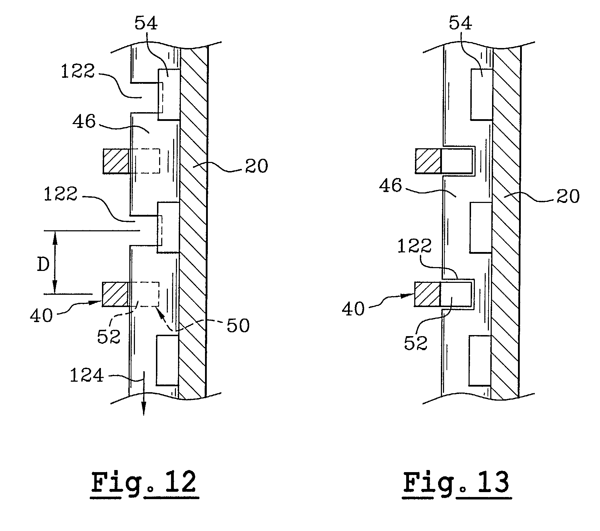

Selon une variante, représentée aux figures 12 et 13 l'élément de verrouillage 46 comporte des encoches 122 dont les dimensions sont sensiblement supérieures à celles de la face de retenue 52 du bec 50 associé.

Les encoches 122 sont décalées longitudinalement d'une distance D de la face de retenue 52 du crochet associé du boîtier 10.

L'assemblage et le verrouillage sont réalisés conformément aux opérations décrites précédemment.

Le démontage du boîtier 10 consiste alors en la translation de la distance D de l'élément de verrouillage 46, selon le sens de la direction longitudinale représentée par la flèche 124 de façon que les encoches 122 soient positionnées en vis-à-vis de la face 52 de retenue en permettant ainsi la libération du crochet 40 et le démontage du boîtier 10.

Ainsi, l'opération de déverrouillage consiste en un petit déplacement longitudinal de l'épingle 90 qui n'est pas extraite du boîtier 10. Cela réduit fortement le risque de perte et/ou d'endommagement de l'épingle 90 lors du démontage du boîtier 10 et du changement de la seconde coque 28.

La description qui précède est réalisée à titre non limitatif. En effet l'inversion mécanique, telle que l'inversion entre la partie supérieure et la partie inférieure sont envisageables sans sortir de l'invention protégée. C'est-à-dire que les crochets peuvent être réalisés sur le corps 24 et que les crans escamotables peuvent être formés sur le couvercle 28 du boîtier 10.

## Revendications

1. Boîtier (10) d'appareil électronique du type qui comporte une partie principale ou corps (24) avec une ouverture (26) et une partie (26), formant couvercle d'obturation de l'ouverture (26), mobile entre une position assemblée sur le corps (24) et une position démontée, du type dans lequel le couvercle (28) comporte au moins un crochet (40) qui s'étend à l'intérieur du corps (24) et qui est retenu, en position assemblée, par un cran (42) escamotable qui est monté mobile, dans des moyens de guidage (44) du boîtier (10), entre une position verrouillée dans laquelle il retient le crochet (40) pour maintenir le corps (24) et le couvercle (28) en position assemblée et une position déverrouillée dans laquelle il libère le crochet (40) pour permettre le démontage de couvercle (28), **caractérisé en ce que** le cran (42) escamotable appartient à un élément de verrouillage (46) qui est guidé en translation selon une direction longitudinale globalement orthogonale à la direction selon laquelle s'étend le crochet (40) et qui comporte une portion de tige (56) longitudinale qui coopère avec le crochet (40), et **en ce que** le boîtier (10) comporte des moyens de retenue (60) de la portion de tige (56) en position verrouillée.

2. Boîtier (10) d'appareil électronique selon revendication précédente, **caractérisé en ce que** le couvercle (28) comporte au moins deux crochets (40) qui sont retenus en position assemblée par au moins deux portions (56) associées de tige appartenant à un élément de verrouillage (46) commun aux deux crochets (40).

3. Boîtier (10) d'appareil électronique selon la revendication précédente, **caractérisé en ce que** les deux crochets (40) sont sensiblement alignés longitudinalement, et **en ce que** l'élément de verrouillage (46) commun est une tige dont deux tronçons forment lesdites portions de tige (56) dont chacune coopère avec un crochet (40) associé.

4. Boîtier (10) d'appareil électronique selon l'une revendications 2 ou 3, **caractérisé en ce qu'**il comporte au moins deux crochets (40) qui sont opposés transversalement, et **en ce que** l'élément de verrouillage (46) est une épingle (90) en forme de U dont les deux branches (92, 94) longitudinales parallèles portent respectivement deux portions de tige (56) dont chacune coopère avec un crochet (40) associé.

5. Boîtier (10) d'appareil électronique selon la revendication précédente, **caractérisé en ce que**, en position verrouillée, la branche (96) transversale intermédiaire de l'épingle (90) en forme de U, formant organe de préhension, est reçue dans un premier logement (98) formé dans une paroi du boîtier (10).

6. Boîtier (10) d'appareil électronique selon la revendication précédente, **caractérisé en ce que** les moyens de retenue (60) comportent un bossage (104) qui s'étend, à l'intérieur du premier logement (98), et qui, en position verrouillée s'étend en regard de la branche intermédiaire (96), de façon à immobiliser l'élément de verrouillage (46) au moins dans un sens selon la direction longitudinale.

7. Boîtier (10) d'appareil électronique selon l'une des revendications 5 ou 6, **caractérisé en ce que** les moyens de retenue (60) comportent un volet de blocage (110) qui est monté mobile, dans une paroi du boîtier (10), entre une position de blocage et une position effacée de façon à empêcher ou non le mouvement de la branche intermédiaire de l'élément de verrouillage (46) au moins dans un sens selon la direction longitudinale.

8. Boîtier (10) d'appareil électronique selon l'une quelconque des revendications précédentes, **caractérisé en ce que** les moyens de retenue (60) comportent au moins un second logement (62) dans lequel est réalisé au moins un trou (64) qui reçoit par engagement serré au moins une extrémité libre (66) de l'élément de verrouillage (46) de façon à arrêter ce dernier en translation longitudinale.

9. Boîtier (10) d'appareil électronique selon l'une quelconque des revendications précédentes, **caractérisé en ce que** l'élément de verrouillage (46) comporte une zone de retenue (112), telle qu'une variation de section, qui en position verrouillée, coopère avec un organe complémentaire (116), telle qu'une pince.

10. Appareil électronique formé d'un boîtier selon l'une des revendications 1 à 9.
